# EUROPEAN PATENT APPLICATION

(11) **EP 3 163 629 A1**
(43) Date of publication of application: **03.05.2017**
(21) Application number: 15460099.3
(22) Date of filing: 26.10.2015
(51) Int. Cl.: H01L 31/0224, H01L 31/048

(54) **A SEMI-ELASTIC PHOTOVOLTAIC MODULE**

(71) Applicant: ML SYSTEM Spólka Akcyjna, 36-062 Zaczernie (PL)
(72) Inventor: Cycon, Dawid, 35-317 Rzeszów (PL); Chochorowski, Wiktor, 35-111 Rzeszów (PL); Pyzik, Marcin, 39-321 Tuszyma (PL); Chrobak, Slawomir, 36-220 Jasienica Rosielna (PL)
(74) Representative: Warzybok, Tadeusz

(57) **Abstract**

The subject of the invention is a semi-elastic photovoltaic module comprising a set of photovoltaic cells placed between two EVA film encapsulants, of which one is covered with a strengthened glass pane, and the other with an electrically insulating film provided with connectors and a connection cable, whereas all these components are hermetically laminated together and set in a rigid aluminium frame, characterised in that it has an upper outer transparent glass pane (1) and a lower outer glass pane (2), each of them 0.5-1.35-mm thick and chemically strengthened; further, two amorphous film encapsulants (3 and 4), each of them 0.5-0.8-mm thick; and monocrystalline or polycrystalline photovoltaic cells (8) placed between the film encapsulant (3) and a current-conducting film (5), said cells manufactured preferably with the use of Metal Wrap Through (MWT) technology. The surface of the current-conducting film (5) is provided with negative electrodes (7) and positive electrodes (6), on which, through perforation holes provided in the cells, base contacts (13) and emitters (12) of the cells, respectively, are put over, while between the emitters and the base contacts there is a coat of a current-conducting binder-adhesive (14) applied with some isolated non-conducting areas (15), said coat connecting the contacts with the current-conducting film (5), and all components of the module are laminated together constituting thus a monolithic structure.

## Description

The subject of the present invention is a semi-elastic photovoltaic module designed to acquire electric power by means of conversion of solar light energy.

From materials published on websites of Polish companies "Bison Energy" and "Hoven" known is a photovoltaic module comprising a set of silicon photovoltaic cells connected with each other, placed between two layers of ethylene-vinyl acetate (EVA) film, and protected with an outer pane of hardened glass and electrically insulating film from the bottom, or with the set of such cells placed between an EVA film and a polyethylene terephthalate (PET) film. The whole of these structures is hermetically laminated and set in a rigid aluminium frame encompassing a hardened glass pane, or the frame holds a PET film together with cells, which secures mechanical strength of the module, whereas the bottom electrically insulating film is provided with a cable connected with solar connectors by means of a junction box, containing the so-called by-pass diodes.

Known from description of German patent DE4222806A1 is an integrated photovoltaic module with a solar heat collector comprising photovoltaic cells connected with each other in parallel-series, said cells being covered from their front side with a transparent element and on their back side, integrated with a heat exchanger.

From Polish patent description PL203881B1 known is a photovoltaic module integrated with a heat exchanger in which photovoltaic cells are situated under a transparent cover mounted in a frame with a metal plate also set in said frame. The space between the transparent cover and the metal plate forms a water chamber provided with inlet and outlet ferrules, and an absorption plate is positioned on the outer side of the metal plate.

Also known from description of German patent application DE10102918(A1) is a composite panel for acquisition of solar energy comprising a load-carrying layer, a heat exchanger layer in the form of a finned plate, a layer connected with photovoltaic cells, and a transparent covering layer.

Description of Polish patent application PL401914 reveals a photovoltaic module integrated with a panel of heat tubes in which to a mounting frame, a photovoltaic module and a panel of heat tubes are fixed, and between the module and the copper plate there is a heat-conducting mass, whereas the panel of heat tubes has a thermal insulation adhering thereto, while both the photovoltaic module and the panel of heat tubes are attached to the mounting frame and fixed to it by means of pressure elements, and permanent joint between them is obtained by means of a fixing binder.

Further, from description of Polish patent application PL402953 known is a photovoltaic module to be used to generate electric power from solar energy and comprising a luminescence concentrator designed to convert the incident light and at least one photovoltaic cell. The essential idea characterising the photovoltaic module consists in that it comprises a glass core designed to transport the light and a layer of absorber made of polymethyl methacrylate or polycarbonate with a luminescent dye playing the role of a concentrator, with the index of refraction of the absorber being lower than the index of refraction of the core, where the photovoltaic cell(s) is(are) coplanar with the surface of the module. Further, side edges of the photovoltaic module are coated with a reflexive surface mirroring the light towards its interiors, and its core is fabricated as a multi-layered structure of at least two layers to increase its mechanical resistance. On the absorber layer side there is at least one photovoltaic cell which can be placed either on the back surface of the module, i.e. on the side opposite to the surface on which the sunrays fall, or in the absorber layer cavity, so that the cell constitutes a single monolithic layer with the absorber.

The objective of the present invention is to provide a new design of the semi-elastic photovoltaic module with structure based on ultra-thin glass panes and an amorphous encapsulant housing polycrystalline or monocrystalline cells made with the use of MWT (Metal Wrap Through) technology ensuring much better optimisation of the module from the point of view of efficiency of converting solar radiation into electric power, allowing to reduce the overall weight of the photovoltaic module, increase its mechanical strength, and improve efficiency of its operation. Another objective of the present invention is also to develop such a design of the photovoltaic module which will be characterised with significant elasticity allowing to install it on e.g. curved roofs of boat superstructures, bus stop canopies with cylindrical roofs, and similar objects. Yet another objective of the invention is to ensure that the new design of the photovoltaic module will represent higher aesthetic qualities allowing to use it as the material classified among the so-called Building-Integrated Photovoltaics (BIPV).

The essential idea behind the structural design of the semi-elastic photovoltaic module consists in that it has an upper outer transparent glass pane and lower outer glass pane, each of them 0.5-1.35-mm thick and chemically strengthened in potassium salt bath, and two amorphous film encapsulants, each 0.5-0.8-mm thick, and monocrystalline photovoltaic cells, made preferably with the use of Metal Wrap Through (MWT) technology, placed between the upper film encapsulant and the current-conducting film. The current-conducting film is provided with negative electrodes and positive electrodes on its surface, and through perforation holes provided in the cells, base contacts of the cells are put over the negative electrodes and emitters of the cells are put over the positive electrodes, while between the emitters and the base contacts there is a coat of a current-conducting binding adhesive applied with isolated non-conducting areas bonding the contacts with the current-conducting film, whereas all components of the module are laminated together constituting a monolithic structure. The amorphous film encapsulants are made of amorphous film characterised with a high degree of translucency in the light wavelengths range 350-1100 nm absorbed by the cells and resistant to external temperatures in the range from -40°C to 90°C as well to other variable atmospheric conditions.

The current-conducting film is favourably provided with by-pass diodes connected with said film by means of epoxy binder with an addition of SnPb or SnCu or AgSn filings. Both encapsulants of the photovoltaic cell can be preferably made of a film containing UV-blockers in its composition or alternatively made of polyvinyl butyral (PVB). The lower outer glass pane of the photovoltaic module is preferably provided additionally with a rigid bordering frame made of a plastic, individual side segments of which are connected to each other by means of right-angled aluminium elements placed inside them, or only the longer sides of the outer glass pane are provided with rigid sectional bars.

Examination of the structural design adopted for the semi-elastic photovoltaic module according to the invention carried out in operating conditions have proved that the solution has many additional merits compared to photovoltaic modules of that type known in the prior art, namely:
- the use of mono- or polycrystalline cells made with the use of MWT technology in the module significantly increases active surface of these cells, and elimination of front electrodes, which in standard solutions are given the shape of H-sections allowed to reduce the adverse shading effect and increase value of the Fill Factor (FF), and thus improve the overall efficiency of converting solar radiation into electric power by the module;
- placing the cells between parallel 0.5-1.35-mm thick thin strengthened float glass panes and 0.5-0.8-mm thick amorphous polymer encapsulant layers allowed to protect the module appropriately against variable atmospheric conditions, as well as reduce its weight and increase transmission properties of the front face of the module, improving thus the transfer of solar energy directly permeating the glass panes, as surface of the chemically strengthened glass has lower light reflection coefficient than this characterising thermally hardened glass panes, and moreover, chemically strengthened float glass increases significantly the mechanical strength of the module and its resistance to variable atmospheric conditions, especially to hail fall;
- the use of MWT technology in providing electric contacts between neighbouring mono- or polycrystalline cells allowed to eliminate current-conducting tapes and, at the same time, reduce distance between neighbouring cells and thus the value of series resistance, and further, allowed to reduce the use of conducting paste which, in standard solutions used in production of photovoltaic cells, forming the so-called front contacts;
- the use of perforated photovoltaic cells and spot joints between the front side with back surface of the cells with the use of the metallization method in the photovoltaic module according to the invention reduces significantly the risk of thermo-mechanical damage and decreases possibility of occurrence of undesirable stresses in soldered connections, extending thus their service life; and moreover
- the use of photovoltaic cells manufactured with the use of MWT technology and spot joints between them as well as using elastic ultra-thin float glass panes in the photovoltaic module according to the present invention allowed to obtain a semi-elastic photovoltaic module capable to be installed also on curved surfaces, while the possibility to modify metallization of the front significantly improves aesthetic qualities of the module allowing to use it as the materials called Building-Integrated Photovoltaics (BIPV);
- further, by making laminate with the by-pass diode located in the centre of the photovoltaic module improved significantly the aesthetic qualities of the module if used as a BIPV material, while the problem of cooling the diode was solved by means of using ultra-thin glass panes which resulted in reduction of material costs. Further, by locating the by-pass diode in the centre of the photovoltaic module, the problem of mounting the module on both flat an arched surfaces, such as e.g. roofs of camper vans or superstructures and decks of boats and yachts, has been successfully solved.

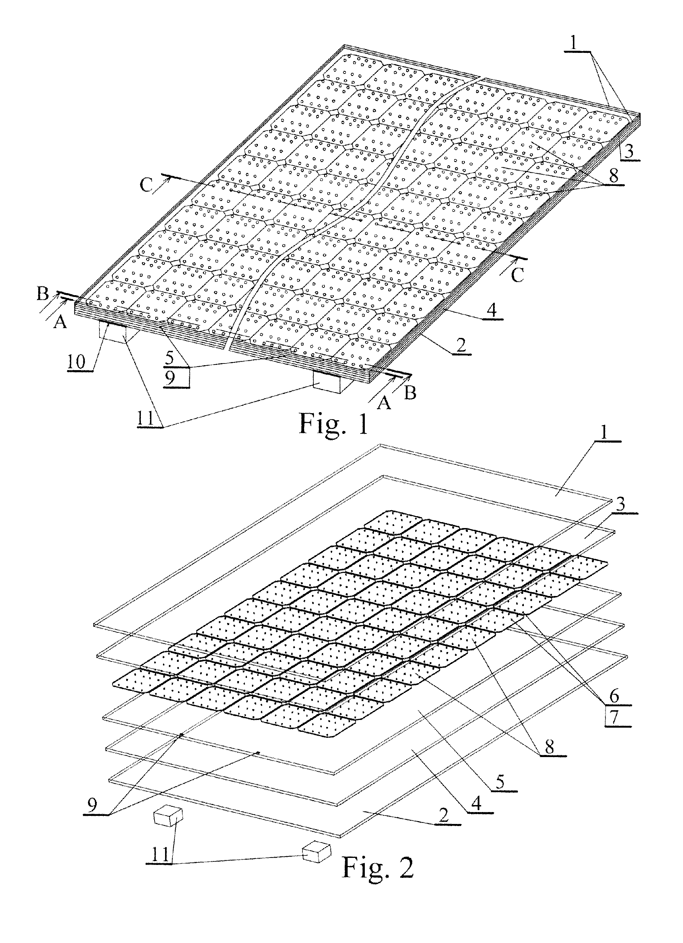

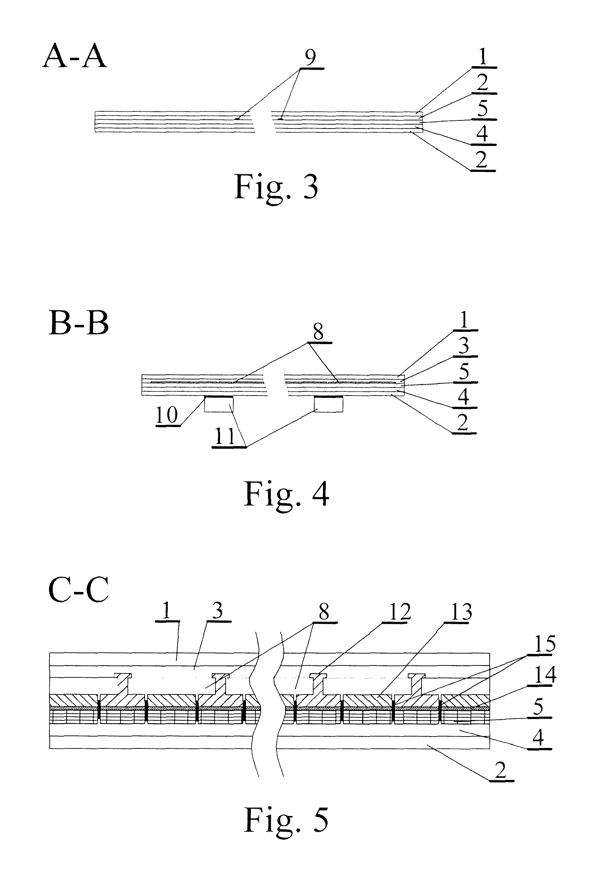

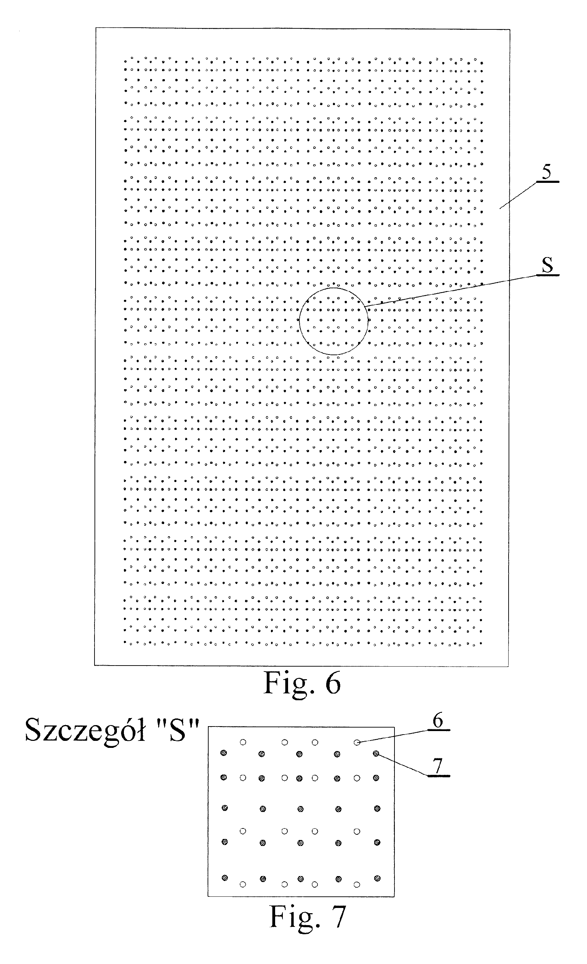

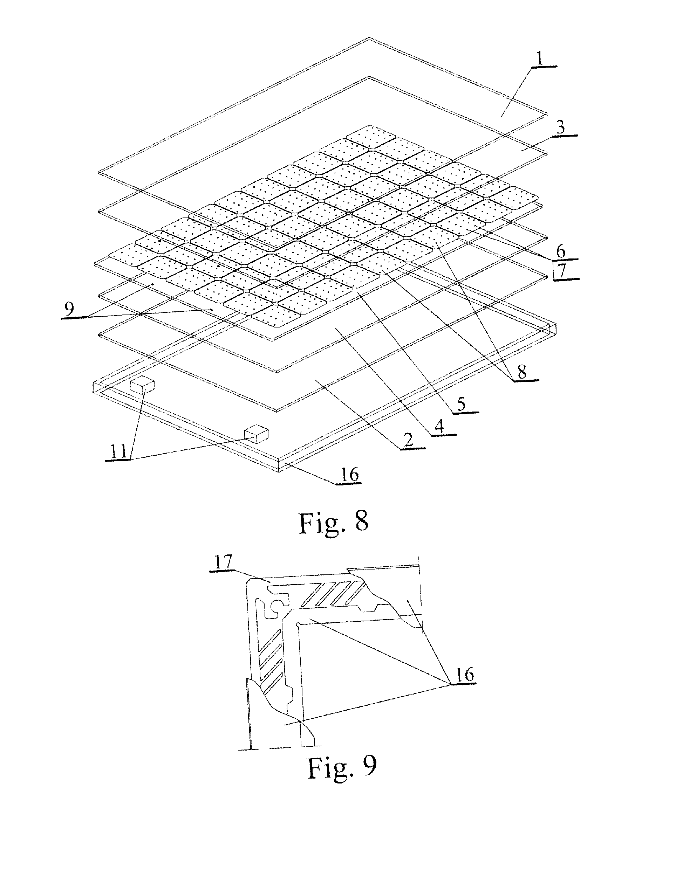

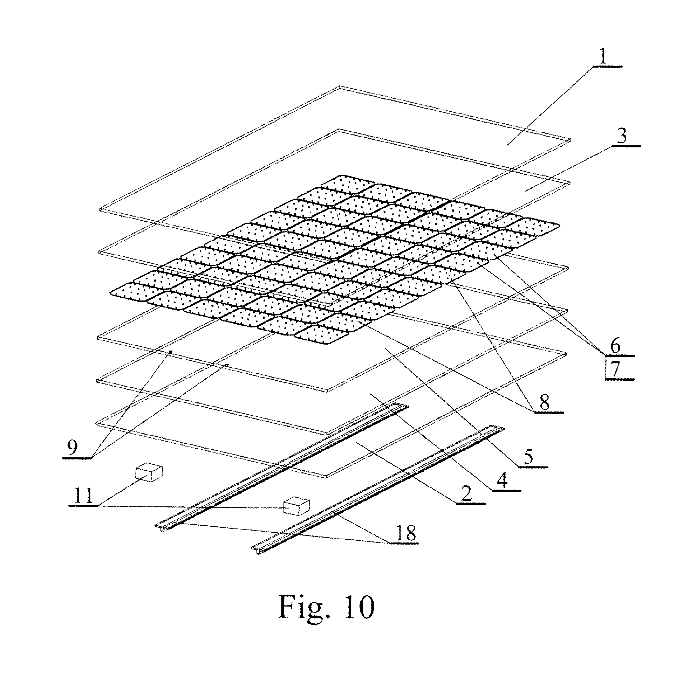

The subject of the invention has been depicted in its example embodiments shown in drawings, of which Fig. 1 presents the first and the second version of the semi-elastic photovoltaic module with photovoltaic cells manufactured with the use of MWT technology without the bordering frame, in a perspective view; Fig. 2 - a schematic representation of the module with its components separated, in a perspective view; Fig. 3 - the same photovoltaic module in the vertical cross-section along line A-A; Fig. 4 - the same photovoltaic module in the vertical cross-section along line B-B, Fig. 5 - the same photovoltaic module in the vertical cross-section along line C-C; Fig. 6 - the film conducting the current generated by the module provided with positive electrodes and negative electrodes, in a top view; Fig. 7 - detail "S" of the current-conducting film of Fig. 6; Fig. 8-the sixth version of the semi-elastic photovoltaic module with photovoltaic cells manufactured with the use of MWT technology, provided with a bordering frame, with its components separated, in a perspective view; Fig. 9 - a fragment of the bordering frame provided with a right-angled connecting element, in a top view; and Fig. 10 - the seventh version of the semi-elastic photovoltaic module with photovoltaic cells, two longer sides of which are provided with stiffening sectional bars with its components separated in a perspective view.

### Example 1

The semi-elastic photovoltaic module according to its first example embodiment presented in Figs. 1-7 comprises an upper outer transparent glass pane 1 and a lower outer glass pane 2, each of which is 0.5-mm thick and chemically strengthened in potassium salt bath, and amorphous film encapsulants 3 and 4, each of them 0.5-mm thick, joined inseparably with said glass panes, with a current-conducting film 5 placed between said encapsulants and provided with positive electrodes 6 and negative electrodes 7, on which monocrystalline photovoltaic cells 8 are placed manufactured with the use of Metal Wrap Through (MWT) technology, with said current-conducting film laid on an amorphous polymer encapsulant 4 and provided with two by-pass diodes 9 mounted in the centre and in parallel into the chain of these photovoltaic cells, the lower outer glass pane 2 being bonded by means of adhesive 10 with two connection terminals 11. In this example embodiment of the photovoltaic module, the total of 60 photovoltaic cells were used with dimensions 156 mm × 156 mm each. Emitters 12 of the photovoltaic cells 8 are put over positive electrodes 6 of the current-conducting film 5 through perforation holes (not shown) provided in the cells, while the back contacts or bases 13 of the cells are put over negative contacts 7 of the film, whereas between emitters 12 and the base 13 there is a coat of low-resistance epoxy-based binder 14 connecting electrodes of the cells with electrodes 6 and 7 of the current-conducting film 5, which has also certain isolated non-conducting areas 15. Also by-pass diodes 9 are connected additionally with the film 5 conducting the current generated by the photovoltaic cells 8 by means of epoxy-based binder 14 with an addition of SnPb filings at temperature 40°C. All components of the photovoltaic module are inseparably integrated by means of the known method of lamination forming together a monolithic structure protected against adverse external factors.

### Example 2

The photovoltaic module according to its second example embodiment has the structure identical to this of the photovoltaic module described in the Example 1 of its embodiment presented in Figs. 1-7 with the difference that in this example the following variations were adopted:
- both outer transparent glass panes 1 and 2 are 1.35-mm thick;
- monocrystalline photovoltaic cells 8 fabricated with the use of the multi-busbar technology;
- encapsulants 3 and 4 made of EVA SAFE film;
- 72 monocrystalline photovoltaic cells 8 are used (not shown);
- connections of three by-pass diodes 9 (not shown) with the film 5 conducting current generated by photovoltaic cells 8 are provided by means of epoxy-based binder 14 with an addition of SnCu;
- film encapsulants 3 and 4, both 0.8-mm thick,
whereas in this very embodiment of the photovoltaic module, to connect by-pass diodes 9 with the film 5 conducting current generated by photovoltaic cells 8, an epoxy-based binder 14 with an addition of AgSn was used as well as encapsulants 3 and 4 made of polyvinyl butyral (PVB).

### Example 3

The photovoltaic module according to its third example embodiment has the structure identical to this of the photovoltaic module described in Example 1 of its embodiment with the difference that in this example the following variations were adopted: 80 silicon polycrystalline or monocrystalline cells were used; both outer glass panes (1 and 2) were 0.85-mm thick; and four by-pass diodes 9 were connected with the current-conducting film 5.

### Example 4

The photovoltaic module according to its fourth example embodiment shown in Figs. 1-7 has the structure identical to this of the photovoltaic module described in Example 1 with the difference that in this example, perovskite cells were used and outer glass panes (1 and 2) were both 0.85-mm thick.

### Example 5

The photovoltaic module according to its fifth example embodiment presented in Figs. 1-7 has the structure identical to this of the photovoltaic module described in Example 1 with the difference that in this example embodiment, dye-sensitised solar cells (DSSC) were used.

### Example 6

The semi-elastic photovoltaic module according to its sixth example embodiment presented in Figs. 8 and 9 has laminar structure identical to this described in Example 1, and the only difference in its design consists in providing the photovoltaic module according to said first example embodiment presented in Figs. 1-7 with a stiffening monolithic rectangular bordering frame 16, individual segments of which, made of a plastic, preferably polyvinyl chloride (PVC), are joined by means of right-angled aluminium elements 17 placed inside them.

In subsequent embodiments of the sixth version of the photovoltaic module according to the present invention, the stiffening frame 16 was made of a plastic of the type of polypropylene carbonate (PPC) or polyphenylene sulfide (PPS) or acrylonitrile styrene acrylate (ASA) or thermoplastic polymer acrylonitrile butadiene styrene (ABS); said plastics, depending on the needs following from operating conditions of cells used in the modules, were additionally reinforced with an additive of glass fibre in the range 5-30% by weight.

### Example 7

The semi-elastic photovoltaic module according to its seventh example embodiment presented in Fig. 10 has the laminar structure analogous to this described in Example 1, and the difference in its structure consists in the use of silicon cells (polycrystalline or monocrystalline) and both outer glass panes (1 and 2) being 0.85-mm; additionally, to increase rigidity of the structure and facilitate assembling of outer glass pane (2), two profiled elements (18) in the form of tee-sections were attached along its longer sides. The joint was made with the use of silicone glue characterised with high adhesion as well as with the use of a two-sided highly-adhesive structural tape which ensured durable and tight joint between the sections with the monolithic structure of the photovoltaic module.

Moreover, in all example embodiments of the semi-elastic photovoltaic module according to the present invention, to fabricate encapsulants 3 and 4, an amorphous film was used characterised with a high degree of translucency in the range of wavelengths from 350 nm to 1100 nm absorbed by the cells and resistant to external temperatures from - 40°C to 90°C as well as to other variable atmospheric conditions. In particular, encapsulating films containing UV-blockers in their composition were used, preferably those with the cut-off wavelength of 380 nm, which allowed to protect the amorphous polymer encapsulate against degrading UV radiation.

## Claims

1. A semi-elastic photovoltaic module comprising a set of photovoltaic cells placed between two ethylene-vinyl acetate (EVA) film encapsulants, of which one is covered with a strengthened glass pane, and the second one with an electrically insulating film, provided in connectors and a connecting cable, whereas all the components are hermetically laminated together and set in a rigid aluminium frame **characterised in that** it has an upper outer transparent glass pane (1) and a lower outer glass pane (2), each of them 0.5-1.35-mm thick and chemically strengthened; further, amorphous film encapsulants (3 and 4), each of them 0.5-0.8-mm thick; and monocrystalline or polycrystalline photovoltaic cells (8), manufactured preferably with the use of Metal Wrap Through (MWT) technology, placed between the film encapsulant (3) and a current-conducting film (5) surface of which is provided with negative electrodes (7) over which base contacts (13) of the cells are put through perforation holes provided therein, and positive electrodes (6) over which emitters (12) of the cells are put through said perforation holes, whereas between the emitters and base contacts there is a coat of current-conducting binder-adhesive (14) with some isolated non-conducting areas (15), bonding the contacts to the current-conducting film (5), and all components of the module are laminated together constituting a monolithic structure.

2. The photovoltaic module according to claim 1 **characterised in that** as the photovoltaic cells (8), perovskite cells are used.

3. The photovoltaic module according to claim 1 **characterised in that** as the photovoltaic cells (8), dye-sensitised solar cells are used.

4. The photovoltaic module according to claim 1 **characterised in that** the current-conducting film (5) is provided with by-pass diodes (9) connected to said film by means of an epoxy-based binder (14) with an addition of SnPb or SnCu or AgSn filings.

5. The photovoltaic module according to claim 1 **characterised in that** the amorphous film encapsulants (3 and 4) are made of amorphous film characterised with a high degree of translucency in the range of wavelengths 350-1100 nm absorbed by the cells and resistant to external temperatures in the range from -40°C to 90°C and to variable atmospheric conditions.

6. The photovoltaic module according to claim 1 or 5 **characterised in that** encapsulants 3 and 4 are made of polyvinyl butyral (PVB) film.

7. The photovoltaic module according to claim 1 or 5 **characterised in that** encapsulants (3 and 4) are made preferably of encapsulant film containing UV-blockers in their composition.

8. The photovoltaic module according to claim 1 **characterised in that** its lower outer glass pane (2) is additionally provided with a rigid bordering frame (16) made of a plastic, with side segments of the frame permanently joined by means right-angled aluminium elements (17) placed inside them.

9. The photovoltaic module according to claim 1 or 8 **characterised in that** both longer sides of its outer glass pane (2) are provided with rigid sectional bars (18).

## Amended claims

### Amended claims in accordance with Rule 137(2) EPC.

1. A semi-elastic photovoltaic module comprising an upper outer transparent strengthened glass pane and a lower outer glass pane, two film encapsulants of EVA or PVB type, and an electric current conducting film, with polycrystalline photovoltaic cells made with the use of metal wrap through (MWT) technology placed between the upper film encapsulant with the upper glass pane adhering thereto and the electric current conducting film, whereas the of the electric current conducting film is provided with negative electrodes on which base contacts of the cells are put through perforation holes provided therein, and positive electrodes on which emitters are put through said perforation holes, whereas between the emitters and base contacts there is a coat of current-conducting binder-adhesive with some isolated non-conducting areas to bond the contacts to the electric current conducting film, all the components of the module being laminated together to form a single monolithic structure **characterised in that** both of the two glass panes (1 and 2) have thickness in the range from 0.5 mm to 1.35 mm and are chemically strengthened in salt bath, each of the two amorphous film encapsulants is 0.5-0.8-mm thick, the photovoltaic cells are perovskite cells or dye-sensitised solar cells (DSSC), and the electric current conducting film (5) is provided preferably with by-pass diodes (9) connected to said film by means of an epoxy-based binder (14) with an addition of SnPb or SnCu or AgSn filings, whereas the two amorphous film encapsulants (3 and 4) are made of an amorphous film characterised with a high degree of translucency for light with wavelengths in the range 350-1100 nm absorbed by the cells and resistant to external temperatures in the range from -40°C to +90°C as well to other variable atmospheric conditions.

2. The module according to claim 1 **characterised in that** both of the amorphous film encapsulants (3 and 4) are made preferably of an encapsulating film containing UV-blockers in its composition.
